(19) Europäisches Patentamt

European Patent Office

Office européen des brevets

(11) **EP 1 729 381 A1**

(12) **EUROPEAN PATENT APPLICATION**
published in accordance with Art. 158(3) EPC

(43) Date of publication:
06.12.2006 Bulletin 2006/49

(51) Int Cl.:
*H01S 5/125* (2006.01)

(21) Application number: 05727098.5

(22) Date of filing: 23.03.2005

(86) International application number:
PCT/JP2005/005246

(87) International publication number:
WO 2005/091452 (29.09.2005 Gazette 2005/39)

(84) Designated Contracting States:
DE FR GB

(30) Priority: 23.03.2004 JP 2004083998

(71) Applicant: NIPPON TELEGRAPH AND
TELEPHONE CORPORATION
Tokyo 100-8116 (JP)

(72) Inventors:
• FUJIWARA, Naoki,
NTT Intellectual Property Center
Musashino-shi, Tokyo 1808585 (JP)
• NUNOYA, Nobuhiro,
NTT Intellectual Property Center
Musashino-shi, Tokyo 1808585 (JP)
• KIKUCHI, Nobuhiro
NTT Intellectual Property Center
Musashino-shi, Tokyo 1808585 (JP)
• SHIBATA, Yasuo,
NTT Intellectual Property Center
Musashino-shi, Tokyo 1808585 (JP)
• YASAKA, Hiroshi,
NTT Intellectual Property Center
Musashino-shi, Tokyo 1808585 (JP)

(74) Representative: TBK-Patent
Bavariaring 4-6
80336 München (DE)

(54) **DBR-TYPE VARIABLE-WAVELENGTH LIGHT SOURCE**

(57) The present invention is to provide a wavelength tunable DBR laser having the wider wavelength tuning characteristic, able to attain a 6nm or more continuous wavelength shift and also higher in output power than a conventional wavelength tunable DBR laser. The DBR laser is constituted such that optical waveguides formed on a substrate, comprising an active region optical waveguide 22 having a light emitting function and passive region optical waveguides 23a and 23b provided on both ends of the active region 22, these passive region optical waveguides 23a and 23b have anterior and posterior DBR regions 24 and 29 with a wavelength tuning function, a posterior DBR region 29 is provided with a diffraction grating whose length is 95% or more in a saturated effective length value, and an anterior DBR region 24 whose length is shorter than the above length to take out the emitting light.

FIG.1A

EP 1 729 381 A1

**Description**

TECHNICAL FIELD

The present invention relates to a wavelength tunable distributed Bragg reflector (DBR) laser, more particularly, relating to a wavelength tunable distributed Bragg reflector (DBR) laser which can attain a continuous wavelength tuning in a wider band by using a single wavelength control current.

BACKGROUND ART

DBR lasers have been used as a wavelength tuning light source for optical communication, and have already been reported the lasing mechanism and wavelength tuning mechanism (for example in Non-Patent Document 1 and Non-Patent Document 2).

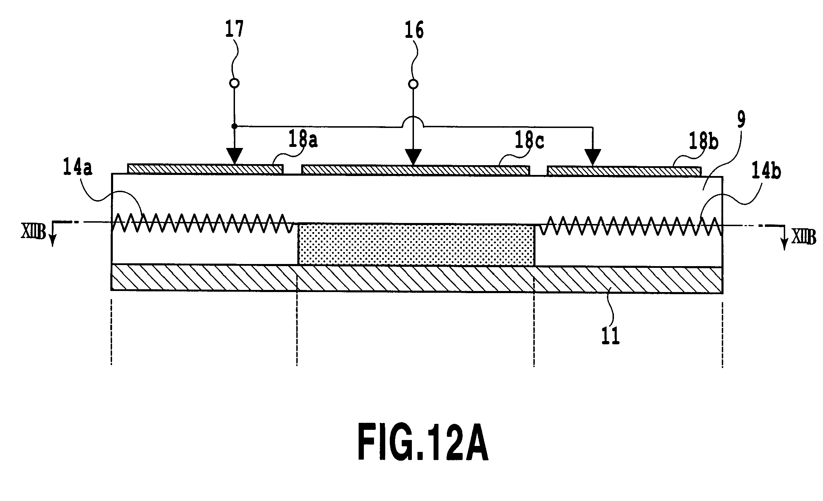

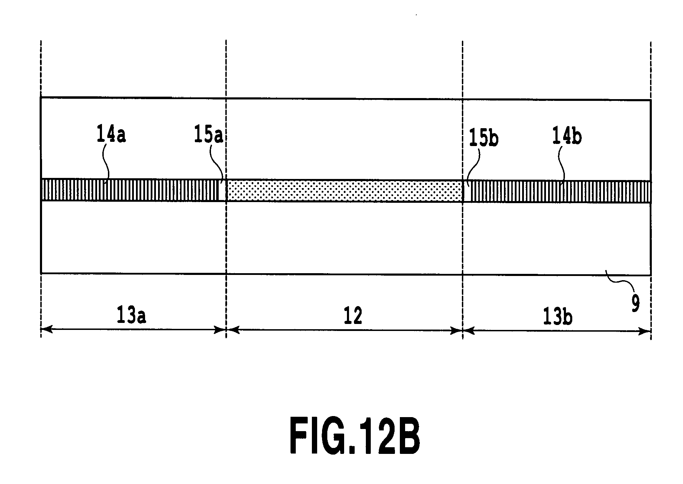

FIG. 12 is a view for explaining a basic structure of a wavelength tunable distributed Bragg reflector (DBR) laser in prior arts. FIG. 12A is a cross sectional view showing a face vertical to a substrate 11 and including an optical waveguide. FIG. 12B is a cross sectional view (top view) showing a face parallel to the substrate 11 and including a cross section taken along line XIIB-XIIB illustrated in FIG. 12A. At the wavelength tunable distributed Bragg reflector (DBR) laser, passive region optical waveguides 13a and 13b are integrated on both sides of an active region optical waveguide 12 provided on the substrate 11. Electrical isolating regions 15a and 15b are provided, respectively, at the active region optical waveguide 12 and on a border of passive region optical waveguides 13a and 13b. In contact with the electrical isolating regions 15a and 15b, DBR (Distributed Bragg Reflector) regions 14a and 14b constituted by a diffraction grating are provided, respectively, in the passive region optical waveguides 13a and 13b. An upper clad layer 9 is formed on the top and the side of each of the above optical waveguides. Lasing wavelength of the wavelength tunable distributed Bragg reflector (DBR) laser is determined by selecting only the longitudinal-mode wavelength available in Bragg reflection band of DBR regions 14a and 14b among longitudinal-mode wavelengths determined by cavity length.

Electrical isolating regions 15a and 15b are high-resistant regions. For forming ohmic contact with electrodes 18a, 18b and 18c, an InGaAsP layer (not illustrated in FIG. 12A) formed on the upper clad layer 9 is partially removed to provide the electrical isolating regions 15a and 15b. Namely, the electrical isolating regions 15a and 15b have functions of isolating and separating an active region current 16 from a DBR control current 17.

Corrugations are formed at a predetermined pitch inside the DBR (Distributed Bragg Reflector) regions 14a and 14b. Light of a wavelength corresponding to the pitch, or light of Bragg wavelength is selectively exposed to an intense reflection. Actually, a high reflection band with several-nm bandwidth is formed at the center of Bragg wavelength and the DBR acts as a diffraction grating inside the high reflection band.

In FIG. 12A, the electrical isolating regions 15a and 15b are denoted as an area where the above-described diffraction grating is not available. Since an electric current will not flow through the electrical isolating regions 15a and 15b, due to a high resistance as explained previously, providing a diffraction grating will not make any contribution to a change in the refractive index in these regions. There may be, therefore, no problems, if a diffraction grating is formed in the electrical isolating regions 15a and 15b.

The wavelength tunable distributed Bragg reflector (DBR) laser is constituted in such a way that an active region current 16 is injected via an electrode 18C into an active region optical waveguide 12, and a DBR control current 17 is injected via electrodes 18a and 18b into DBR regions 14a and 14b. The DBR control current 17 is injected into DBR regions 14a and 14b, by which a change in refractive index will occur in the DBR regions 14a and 14b. In association with the change in refractive index, it is possible to shift both the above-described longitudinal mode wavelength and Bragg wavelength toward shorter wavelengths.

However, sensitivity of the wavelength shift in association with the change in refractive index resulting from injection of the DBR control current 17 into the DBR regions 14a and 14b is greater in the Bragg wavelength than in the longitudinal mode wavelength. Namely, the Bragg wavelength will more quickly shift toward shorter wavelengths, because in a laser cavity constituted by the active region optical waveguide 12 and passive region optical waveguides 13a and 13b, injection of the DBR control current 17 will impart a change in refractive index only to the passive region optical waveguides 13a and 13b or to the DBR regions 14a and 14b. Namely, the Bragg wavelength shift reflects only a change in refractive index in the DBR regions 14a and 14b, whereas the longitudinal mode wavelength shift reflects a change in refractive index in a whole laser cavity. In general, the longitudinal mode wavelength shift quantity can be calculated by the following formula (1).

**[Formula 1]**

$$\frac{\Delta\lambda_C}{\lambda_C} = \frac{\Delta\lambda_B}{\lambda_B} \times \frac{L_{eff-f} + L_{eff-r}}{L_a + L_{eff-f} + L_{eff-r}} \qquad (1)$$

In the above formula (1), $\Delta\lambda_C$ denotes the longitudinal mode wavelength shift quantity; $\lambda_C$ denotes the longitudinal mode wavelength; $\Delta\lambda_B$ denotes the Bragg wavelength shift quantity; $\lambda_B$ denotes the Bragg wavelength; $L_{eff-f}$ and $L_{eff-r}$, respectively, denote the effective length in anterior (front) and posterior (rear) DBR region; $L_a$ denotes the active region length. Herein, $L_{eff}$ is an effective length of DBR regions 14a and 14b. This length is called an effective length and defined according to Non-Patent Document 2.

Here, a detailed explanation will be made for a DBR (distributed Bragg reflector) and its effective length. As described above, corrugations are formed at a predetermined pitch inside the DBR region. Light of a wavelength corresponding to the pitch, or light of the Bragg wavelength, is selectively exposed to an intense reflection. A high reflection band with several-nm bandwidth is formed at the center of the Bragg wavelength and the DBR acts as a diffraction grating inside this high reflection band.

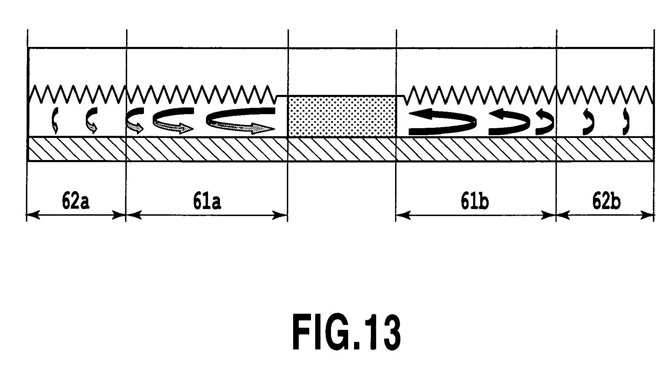

FIG. 13 is a view for explaining how reflection proceeds in the DBR regions 14a and 14b. Light of a wavelength in the high reflection band in which Bragg reflection is produced is subjected to a distributional reflection, as shown in FIG. 13. Therefore, a propagating length detected by light is shorter than an actual length of DBR regions 14a and 14b. This length is called the effective length.

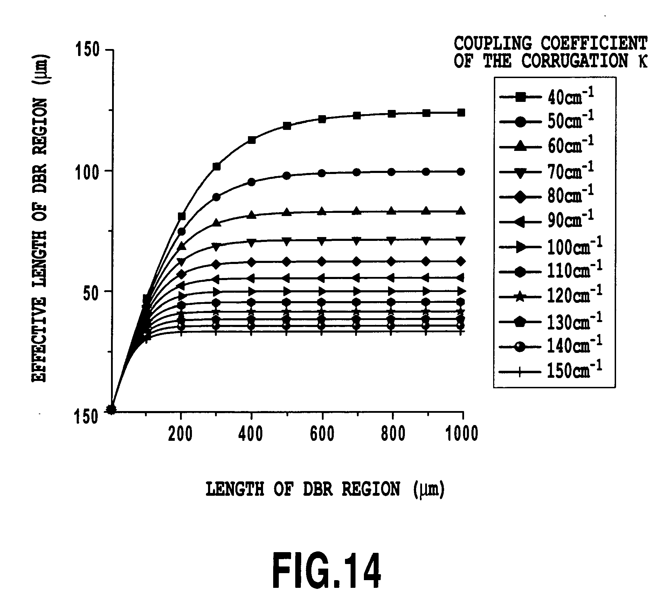

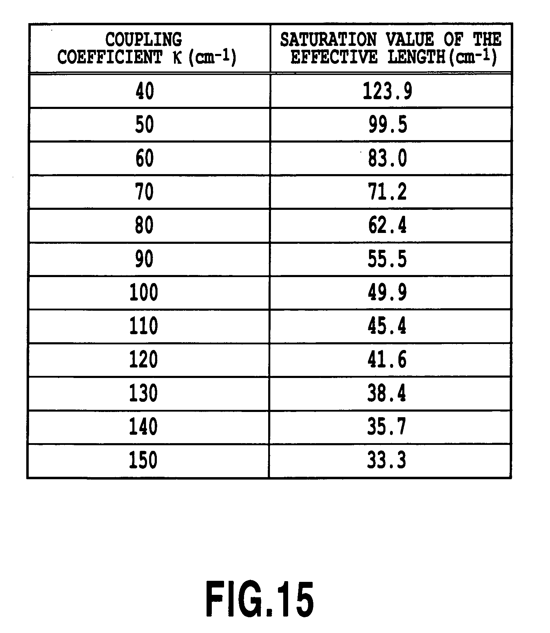

FIG. 14 and FIG. 15 are figures showing calculation results of the effective length in relation to the length of DBR region (on the assumption that waveguide propagating loss $\Gamma\alpha = 10$ cm$^{-1}$) . FIG. 14 is a view in which the coupling coefficient of the corrugation $\kappa$ is used as a parameter to show the relationship of a length of the DBR region with the effective length. FIG. 15 is a tabulation covering a saturated effective length value in individual coupling coefficients $\kappa$.

As shown in FIG. 14 and FIG. 15, where DBR regions 14a and 14b are short in length (where in FIG. 13, the length of the DBR region is in a range in which the length of regions 61a or 61b contributes to an increase/decrease in effective length), the effective length will increase linearly in relation to the length of the DBR region. In contrast, where DBR regions 14a and 14b are made longer in length (where in FIG. 13, the length of the DBR region is in a range in which the length of regions 62a or 62b hardly contributes to an increase/decrease in effective length), values of the effective lengthwill be saturated and converge on a certain saturated effective length value.

As with the effective length, the reflectivity of the DBR region will increase with the length of the DBR region. Propagating light is subjected to the most intense reflection in the DBR region near an active region. Therefore, when the DBR region is made long to some extent, the reflectivity will be convergent to a certain value. As described above, the effective length of a DBR (diffraction grating) is an optical path length detected by propagating light, when a distributional reflection of the diffraction grating is taken into account. Thus, the reflectivity and the effective length show a quite similar behavior of increase/decrease with respect to length of the diffraction grating, namely, DBR region.

Where DBR regions and active region are integrated to constitute a wavelength tunable distributed Bragg reflector (DBR) laser, the reflectivity is influenced by coupling loss at junction parts of active region with DBR regions. Thus the reflectivity is not an appropriate parameter in designing a device. The effective lengths reflecting the reflectivity and free of an influence of the coupling loss at junction parts of active region with DBR regions have been used as parameters in designing a device. The effective lengths of DBR regions are parameter related to laser cavity length, longitudinal mode interval, Bragg reflectivity and others, and it is possible to design an effective DBR laser by taking into account a value of the effective length.

The numerator ($L_{eff-f}$+$L_{eff-r}$) which is the second item from the right in the formula (1) denotes a sum of the effective lengths in refractive index variable regions (namely, DBR regions), the denominator ($L_a$+$L_{eff-f}$+$L_{eff-r}$) denotes an entire cavity length. Strictly, lengths of electrical isolating regions 15a and 15 should be added to the entire cavity length. However, the electrical isolating regions 15a and 15b are constituted in an extremely short interval 5 to 10$\mu$m, and therefore hardly influence an error of the entire cavity length. Therefore, in the formula (1), lengths of electrical isolating regions 15a and 15b are omitted.

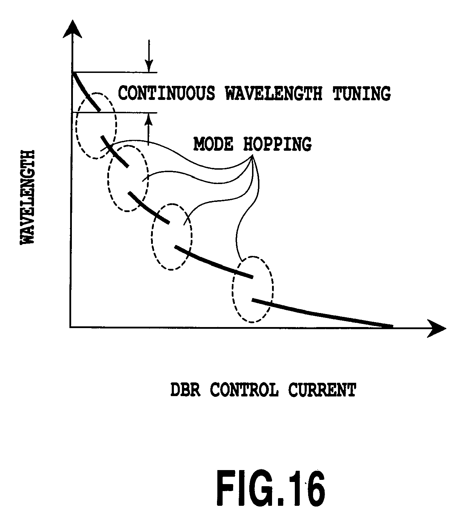

According to the formula (1), the longitudinal mode wavelength shift quantity $\Delta\lambda_C$ is smaller by the coefficient in the second item from the right than the Bragg wavelength shift quantity $\Delta\lambda_B$. Thus, if the DBR control current 17 continues to increase, the longitudinal mode wavelength $\lambda_C$ will finally result in deviation from a Bragg reflection band to long wavelengths (longer side in wavelength), and laser oscillation will shift to another adjacent longitudinal mode on the side of short wavelengths. Namely, mode-hopping occurs. Thus, a continuous increase in DBR control current 17 will result in a shift of lasing wavelength to the shorter wavelengths side, while a continuous wavelength shift and a discrete mode-hopping are repeated. FIG. 16 is a view showing the relationship between DBR control current and lasing wavelength in a wavelength tunable distributed Bragg reflector (DBR) laser in prior arts. Continuous wavelength shift and discrete mode-hopping are repeated frequently. Lasing wavelength exhibits a discrete tuning control characteristic as a whole, which is not favorable. A continuous wavelength tuning width (continuous wavelength shift band width) $\Delta\lambda_{CON}$ can be expressed by the following formula according to Non-Patent Document 3.

[Formula 2]

$$\Delta\lambda_{CON} = \frac{\lambda^2 (L_{eff-f} + L_{eff-r})}{2 n_{eff} L_a (L_a + L_{eff-f} + L_{eff-r})} \qquad (2)$$

In the above formula (2), $\Delta\lambda_{CON}$ denotes a continuous wavelength tuning range, and $n_{eff}$ denotes an effective refractive index. Preferable is a tunable laser whose continuous wavelength tuning range $\Delta\lambda_{CON}$ is wide.

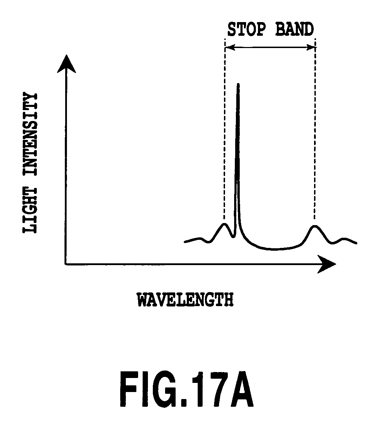

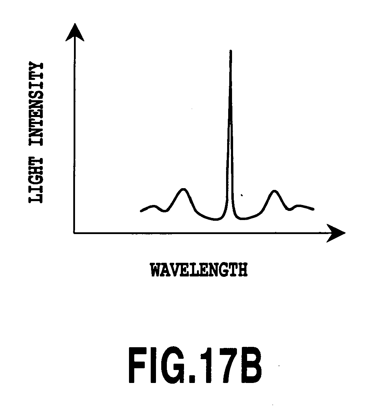

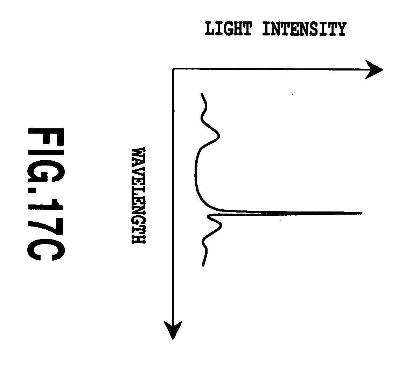

FIG. 17 is a spectral map explaining a wavelength shift in a wavelength tunable distributed Bragg reflector (DBR) laser in the prior arts. The discrete mode-hopping explained above results in a discrete wavelength tuning control characteristic, because there is a difference between the longitudinal mode wavelength and the Bragg wavelength in sensitivity of shift in wavelength with regard to an injection quantity of the above-described DBR control current. As shown in FIG. 17A through FIG. 17C, when the DBR control current is increased continuously, a shift in stop band corresponding to a change in Bragg wavelength is greater in sensitivity than a shift in lasing wavelength corresponding to a change in longitudinal mode wavelength. The stop band will shift to the short wavelength side more quickly. Thus, as with an increase in DBR control current, the lasing wavelength will relatively shift to the long wavelengths side in the stop band (Bragg reflection band). If the DBR control current is increased further beyond a state shown in FIG. 17C, mode-hopping will occur.

A method for preventing the mode-hopping includes that in which a phase control region is added to give a multi-electrode constitution, thereby controlling the wavelength (refer to Non-Patent Document 1). However, in this method, items to be controlled are increased to make the control more difficult. Further, it is difficult to estimate a change in individual control currents when a device is deteriorated with the lapse of time, thus posing problems in actual handling. In order to provide a simple wavelength tuning control in a wide band by using a single control current, as apparent from the previous formula (2), it is most effective to shorten the active region length $L_a$.

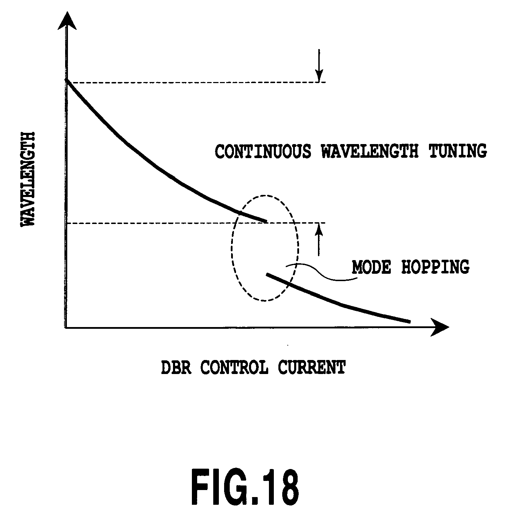

FIG. 18 is a characteristics curve showing the wavelength tuning characteristics of a wavelength tunable distributed Bragg ref lector (DBR) laser in which the active region length $L_a$ is shortened. The shortened active region length $L_a$ can provide a continuously tunable wavelength range in a wide zone, thereby offering a wide mode-hop free band (continuous wavelength tunable) as shown in FIG. 18. In the experimental result given in Non-Patent Document 3, the active region length $L_a$ is allowed to change to fabricate a DBR laser in which a wide band is obtained according to a theoretical value.

Next, a supplementary explanation will be made for the relationship between initial phase conditions of the lasing mode, threshold current and carrier density in a conventional wavelength tunable distributed Bragg reflector (DBR) laser as shown in FIG. 12. In FIG. 12A, a carrier density of the active region optical waveguide 12 abruptly increases with an increase in the active region current 16. Once laser radiation occurs, the carrier density of the active region optical waveguide 12 is clamped (stable at an approximately constant value). A further increase in active region current 16 will result in a very slow increase in carrier density. The refractive index of the active region optical waveguide 12 which determines initial phase condition of a lasing mode will decrease with an increase in carrier density of this region. To be specific, a value of the threshold current will determine the initial phase conditions, and an increase in the threshold current will result in a shift of the lasing mode to the shorter wavelengths side by such increase. Thereafter, an increase in the active region current 16 will hardly affect on the initial phase conditions because the carrier density is clamped.

Where a DBR control current is used to control the wavelength tuning, a decrease in reflectivity associated with injection of the DBR control current 17 will result in an increase in threshold current of the active region current 16. In a DBR laser in which only the length of the active region optical waveguide 12 is shortened, a gain shortage in the active region optical waveguide 12 will occur due to an enlarged continuous wavelength tuning width. In order to supplement the gain shortage, the length of DBR regions 14a and 14b in the vicinity of the active region optical waveguide 12 is made sufficiently long until it reaches a saturated effective length value to give a high reflectivity, thereby preventing a halt of the lasing. Therefore, it was impossible to control the change rate of a threshold current, although the threshold current may increase at the time of controlling the wavelength tuning.

Publicly known literature on disclosure of prior arts includes the following Non-Patent Document 1 through Non-Patent Document 3.

Non-Patent Document 1: Semiconductor Photonics Engineering, pp. 306 to 311, published under general editorship of Tatsuhiko Ikegami by Corona Corporation January 10, 1995

Non-Patent Document 2: Semiconductor Laser, pp. 283 to 288, compiled by Kenichi Iga (the Japan Society of Applied Physics) and published by Ohmsha October 25, 1994

Non-Patent Document 3: Research on high performance process of wavelength tuning semiconductor laser (doctoral thesis), pp. 39 to 43, pp. 54 to 59 and pp. 65 to 68, reported by Hiroyuki Ishii March 1999

DISCLOSURE OF THE INVENTION

Problems to be solved by the Invention

The above-described method which shortens the active region length $L_a$ of the active region optical waveguide 12 is unable to make a continuous wavelength shift far beyond $\Delta\lambda_{CON}$ given in the formula (2), but onlymakes an approximately 3nm-continuous wavelength shift. In order to provide a 6mm or more continuous wavelength shift width, it is necessary to shorten the active region length $L_a$ of the active region optical waveguide 12 by up to approximately $30\mu$m. Then, in order to supplement the gain shortage of the active region optical waveguide 12 caused by the shortened active region length $L_a$, it is necessary to make the DBR region 14 longer so as to obtain a high reflectivity. Consequently, the above conventional DBR laser results in a low-power light source. In addition, unless the active region length $L_a$ and gain of the active region optical waveguide 12 as well as phase conditions of the lasing mode are strictly determined in advance, problems such as mode-hopping occur instantly after start of the wavelength shift.

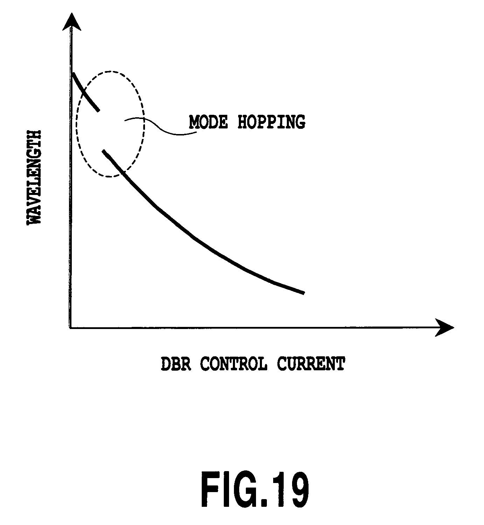

FIG. 19 is a view showing the wavelength tuning characteristics in a case where initial phase condition is not appropriate in a wavelength tunable distributed Bragg reflector (DBR) laser in which the active region length $L_a$ is shortened. As shown in FIG. 19, unless the above-described condition is appropriately designed, mode-hopping occurs instantly after start of the wavelength shift, thus posing practical problems.

In view of the above described problems found in the prior arts, an object of the present invention is to provide a wavelength tunable distributed Bragg reflector (DBR) laser which is provided with the wavelength tuning characteristic capable of attaining a continuous tuning control of the lasing wavelength in a wider band, namely, a continuous wavelength shift, and which is able to attain a 6nm or longer continuous wavelength shift and also higher in output power than a conventional wavelength tunable distributed Bragg reflector (DBR) laser.

Means for Solving the Problem

In order to attain the above object, the present invention is constituted with a wavelength tunable distributed Bragg reflector (DBR) laser having optical waveguides surrounded by a clad layer on a substrate, comprising a first passive region optical waveguide including a first DBR region having a diffraction grating in a section whose length corresponds to effective length of 95% or more in a saturated effective length value, wherein the lasing wavelength is controlled by a DBR control current, a second passive region optical waveguide including a second DBR region having a diffraction grating in a section whose length is shorter than the first DBR region, wherein the lasing wavelength is controlled by the DBR control current, and an active region optical waveguide in which the first passive region optical waveguide and the second passive region optical waveguide are optically connected at both ends, wherein emission state is controlled by the active region current, irrespective of the DBR control current.

Further in order to obtain a high output power, it is preferable that the effective length of the diffraction grating in the anterior (second) DBR region is formed so as to give 75% or less in a saturated effective length value, and an anti-reflection film is given to end faces of both DBR regions. It is more preferable that a ratio of the lasing wavelength shift quantity and the Bragg wavelength shift quantity is in a range from 0.9 to 1.1. Where the ratio falls in this range, mode-hopping will not occur in most cases, even though complete mode-hop free conditions (ratio of the lasing wavelength shift quantity to the Bragg wavelength shift quantity is 1) are not obtained.

Another embodiment of the present invention is structured with a wavelength tunable distributed Bragg reflector (DBR) laser having optical waveguides surrounded by a clad layer on a substrate, comprising a first passive region optical waveguide including a first DBR region having a diffraction grating in a section whose length corresponds to effective length of 75% or less in a saturated effective length value, wherein lasing wavelength is controlled by a DBR control current, a second passive region optical waveguide including a second DBR region having the diffraction grating in a section whose length corresponds to effective length of 75% or less in a saturated effective length value, wherein the lasing wavelength is controlled by the DBR control current, an active region optical waveguide in which the first passive region optical waveguide and the second passive region optical waveguide are optically connected at both ends, wherein emission state is controlled by the active region current, irrespective of the DBR control current, a high-reflection film which coats an end face of the first passive region optical waveguide opposite the active region optical waveguide, and an anti-reflection film which coats an end face of the second passive region optical waveguide opposite the active region optical waveguide.

Another embodiment of the present invention is structured with a wavelength tunable distributed Bragg reflector (DBR) laser having optical waveguides surrounded by a clad layer on a substrate, comprising a passive region optical waveguide including a DBR region having a diffraction grating in a section whose length corresponds to effective length of 75% or less in a saturated effective length value, wherein the lasing wavelength is controlled by a DBR control current, an active region optical waveguide which is optically connected to the passive region optical waveguide, wherein emission state is controlled by the active region current irrespective of the DBR control current, an anti-reflection film which coats an end face of the passive region optical waveguide opposite the active region optical waveguide and a high-reflection film which coats an end face of the active region optical waveguide opposite the passive region optical waveguide. To be specific, it is preferable in making a light source smaller in size to replace a long (first) DBR region by a high-reflection film.

A proper determination of the reflectivity in the DBR region makes it possible to optimize an increase/decrease rate of lasing threshold, thereby providing a light source that satisfies the relationship given in the formula (3).

In order to provide a continuous wavelength shift in a wider band and also increase the output power of a light source, it is preferable that a posterior DBR region 29 is made sufficiently long so as to yield a high reflectivity and an anterior DBR region 24 is made shorter in length. This is because where a DBR region is short on the outgoing side of emitting light, light transmittance will be improved. As described above, since the reflectivity and the effective length are correlated, the length of the anterior DBR region 24 is allowed to increase or decrease in a range lower than the critical length contributing to an increase/decrease in effective length (regions 61a and 61b contributing to an increase/decrease in effective length as shown in FIG. 13), thereby making it possible to control an increase rate $\Delta I_{th}$ of the threshold current at the time of controlling the lasing wavelength shift and also to enlarge a continuous wavelength tuning quantity (tuning width).

As explained in the background art, an effective length varies depending on the length of a DBR region. An effective length saturated to a certain value where the DBR region is made sufficiently long ($1000\ \mu$m in length) is shown as a saturated effective length value in FIG. 15. The coupling coefficient of the corrugation $\kappa$ tabulated in FIG. 15 is in a range which can be relatively easily provided by a method for fabricating an ordinary DBR laser (wet etching or dry etching). Keeping in this range the effective length of a DBR region to 75% or less in a saturated effective length value provides a transmittance of approximately 50 % (or more), thereby giving a higher output power of light.

According to the wavelength tunable distributed Bragg reflector (DBR) laser of the present invention, it is possible to control appropriately a change rate of the threshold current at the time of controlling the lasing wavelength shift, and provide a continuous wavelength shift in a wide band in excess of theoretic values of a conventional continuous wavelength tuning range ($\Delta\lambda_{CON}$ in the formula (2)), besides a higher output power of emitting light.

BRIEF DESCRIPTION OF THE DRAWINGS

FIG. 1A is a cross sectional view showing the wavelength tunable distributed Bragg reflector (DBR) laser according to Embodiment 1 of the present invention;

FIG. 1B is a cross sectional view taken along line IB-IB in the wavelength tunable DBR laser described according to Embodiment 1 of the present invention;

FIG. 2A is a view showing the wavelength tunable DBR laser according to Embodiment 2 of the present invention;

FIG. 2B is a top view or a cross sectional view taken along line IIB-IIB in the wavelength tunable DBR laser according to Embodiment 2 of the present invention;

FIG. 3A is a view explaining spectra in the wavelength shift of the wavelength tunable DBR laser according to the embodiment of the present invention;

FIG. 3B is a view explaining spectra in the wavelength shift of the wavelength tunable DBR laser according to the embodiment of the present invention;

FIG. 3C is a view explaining spectra in the wavelength shift of the wavelength tunable DBR laser according to the embodiment of the present invention;

FIG. 4 is a characteristics curve showing the wavelength tuning characteristics of the wavelength tunable DBR laser according to the embodiment of the present invention;

FIG. 5 is a characteristics curve showing a ratio of the lasing wavelength shift quantity to the Bragg wavelength shift quantity;

FIG. 6 is a characteristics curve showing the wavelength tuning characteristics of the wavelength tunable DBR laser according to Embodiment 1 of the present invention;

FIG. 7 is a characteristics curve showing a difference between the lasing wavelength according to Embodiment 1 of the present invention and the theoretical value obtained according to the formula (1);

FIG. 8 is a characteristics curve showing the I-L characteristics of the wavelength tunable DBR laser according to Embodiment 1 of the present invention;

FIG. 9 is a characteristics curve showing a comparison of the value given in FIG. 7 with the wavelength shift caused by change in threshold current in the wavelength tunable DBR laser according to Embodiment 1 of the present invention;

FIG. 10A is a cross sectional view showing the wavelength tunable DBR laser according to Embodiment 3 of the present invention;

FIG. 10B is a cross sectional view taken along line XB-XB in the wavelength tunable DBR laser according to Embodiment 3 of the present invention;

FIG. 11 is a block diagram of the integrated wavelength tunable DBR laser array according to Embodiment 4 of the present invention;

FIG. 12A is a cross sectional view showing the constitution of a conventional wavelength tunable DBR laser;

FIG. 12B is a cross sectional view taken from line XIIB-XIIB in a conventional wavelength tunable DBR laser;

FIG. 13 is a view showing how light reflection proceeds;

FIG. 14 is a characteristics curve showing a dependency of the effective length on the length of the DBR region;

FIG. 15 is a tabulation of a saturated effective length value;

FIG. 16 is a characteristics curve showing the wavelength tuning control characteristic of a conventional wavelength tunable DBR laser;

FIG. 17A is a view showing spectra in the wavelength shift of a conventional wavelength tunable DBR laser;

FIG. 17B is a view explaining spectra in the wavelength shift of a conventional wavelength tunable DBR laser;

FIG. 17C is a view explaining spectra in the wavelength of a conventional wavelength tunable DBR laser;

FIG. 18 is a characteristics curve showing the wavelength tuning characteristics of the wavelength tunable DBR laser in which the active region is shortened; and

FIG. 19 is a characteristics curve showing the wavelength tuning characteristics in a case where initial phase conditions are not appropriate in the wavelength tunable DBR laser in which the active region is shortened.

BEST MODE FOR CARRYING OUT THE INVENTION

An explanation will be made for the embodiment of the present invention by referring to the following figures.

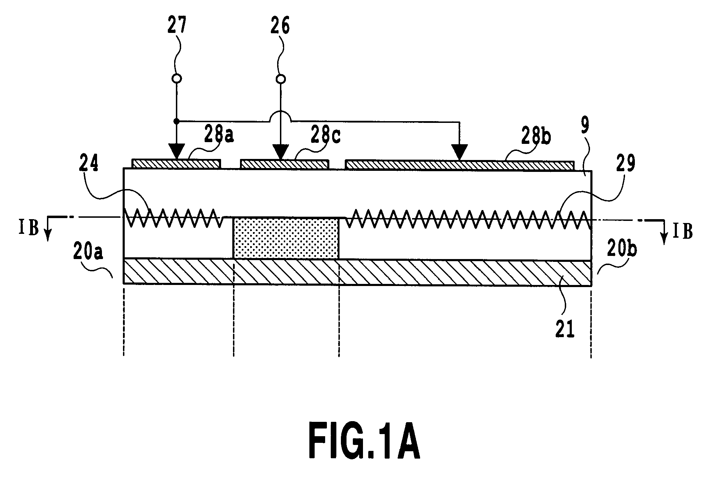

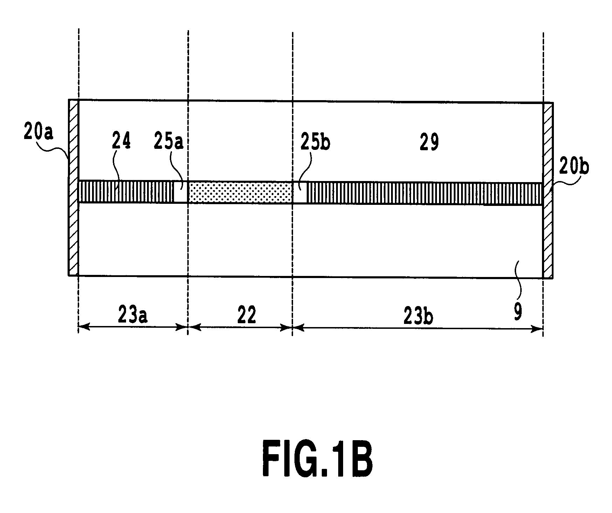

FIG . 1 is a view showing a structure of the wavelength tunable distributed Bragg reflector (DBR) laser in the embodiment of the present invention. As shown in FIG. 1, on a substrate 21 provided are an active region optical waveguide 22 having light-emitting functions such as current injection and optical excitation as well as passive region optical waveguides 23a and 23b which are on both ends of the active region optical waveguide 22 and able to control the lasing wavelength by electric current injection and optical excitation. A band gap of the passive region optical waveguides 23a and 23b is larger than that of the active region optical waveguide 22. These active region optical waveguide 22 and passive region optical waveguides 23a and 23b constitute an optical waveguide of the wavelength tunable distributed Bragg reflector (DBR) laser of the present invention.

Further, the posterior passive region optical waveguide 23b is provided with a DBR region 29, the DBR effective length of which is sufficiently long and corresponds to 95% or more in a saturated effective length value, and with an electrical isolating region 25b. Therefore, the DBR region 29 is of a sufficiently high reflectivity. The anterior passive region optical waveguide 23a on the opposite side through the active region optical waveguide 22 is provided with an anterior DBR region 24, whose DBR effective length is shorter than the length of the posterior DBR region 29, and with an electrical isolating region 25a.

As explained above, even in the wavelength tunable distributed Bragg reflector (DBR) laser driven by the active region current 26 at a constant value, the active region optical waveguide 22 is increased in carrier density as well, when the active region current 26 is increased in threshold current, and decreased in refractive index in association with such an increase in carrier density.

A decreased refractive index of the active region optical waveguide 22 is effective in shifting a longitudinal mode wavelength $\lambda_C$ toward a short wavelength. Thus, if the Bragg wavelength shift quantity $\Delta\lambda_B$ determined by injection of the DBR control current 27 is allowed to coincide with the longitudinal mode wavelength shift quantity $\Delta\lambda_C$ determined by injection of the DBR control current 27 and an increase in threshold current, the Bragg wavelength $\lambda_B$ and the longitudinal mode wavelength $\lambda_C$ are linked and shifted together, thus making it possible to solve problems of mode-hopping. This means that the numerator ($L_{eff-f}+L_{eff-r}$) is equal to the denominator ($L_a+L_{eff-f} + L_{eff-r}$) and the longitudinal mode wavelength shift quantity $\Delta\lambda_C$ is expressed by the following formula (3).

[Formula 3]

$$\frac{\Delta\lambda_C}{\lambda_C} = \frac{\Delta\lambda_B}{\lambda_B} \qquad (3)$$

This formula (3) means that a refractive index of all optical waveguides decrease equally. Namely, the refractive index of the active region optical waveguide 22 decreases equally with the decrease in refractive index of the anterior DBR region 24 and the posterior DBR region 29. Thus, as long as the refractive index of the DBR region 24 continues to decrease in association with injection of the DBR control current 17, the lasing wavelength (longitudinal mode wavelength) shifts to shorter wavelengths without causing mode-hopping. Therefore, unless a device is strictly designed, with initial phase conditions taken into account, there is no such a phenomenon that mode hopping will occur instantly after start of wavelength shift as shown in FIG. 19.

For realizing the above description, the reflectivity of the DBR region is appropriately determined to optimize an increase/decrease rate of the threshold current, thereby providing a light source which can satisfy the relationship of the formula (3). In order to obtain a continuous wavelength shift in a wide band and a higher output power of light at the same time, it is preferable that a posterior DBR region 29 is made sufficiently long so as to yield a high reflectivity and an anterior DBR region 24 is made shorter in length. This is because where a DBR region is short on the outgoing side of emitting light, light transmittance will be improved. As described above, since the reflectivity and the effective length of the DBR region are correlated, the length of the anterior DBR region 24 is allowed to increase or decrease in a range that the length is shorter than the critical length contributing to an increase/decrease in effective length (regions 61a and 61b contributing to an increase/decrease in effective length as shown in FIG. 13), thereby making it possible to properly control an increase rate $\Delta I_{th}$ of the threshold current at the time of the wavelength tuning and also enlarge a continuous wavelength shift.

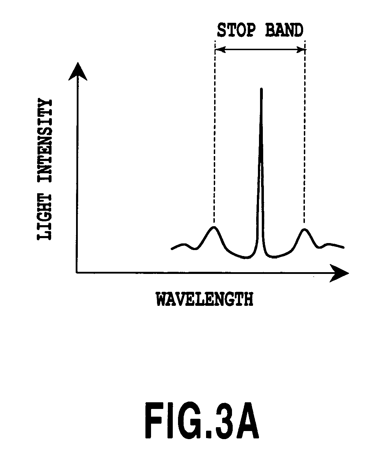

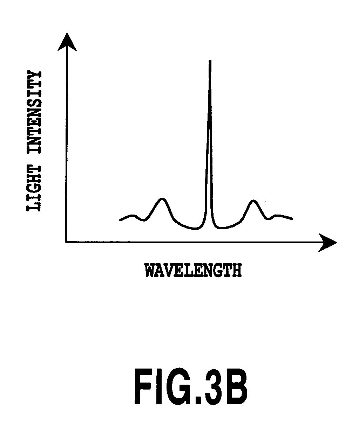

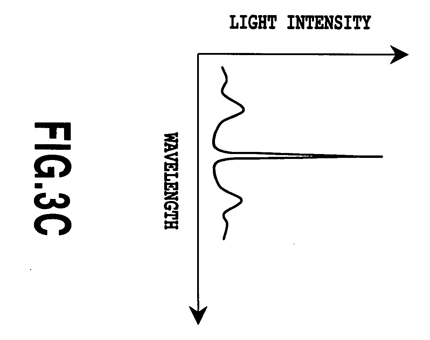

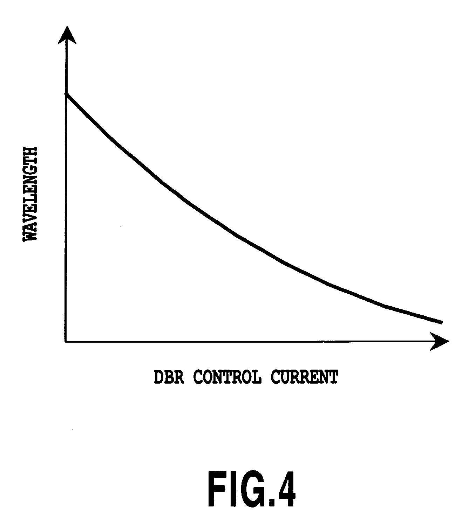

FIG. 3 is a view explaining spectra in wavelength shift of the wavelength tunable distributed Bragg reflector (DBR) laser according to the embodiment of the present invention. In the present invention, as shown in FIG. 3A through FIG. 3C, an increase in DBR control current results in a shift of both the Bragg wavelength (stop band) and the lasing wavelength toward shorter wavelengths by an equal quantity, when the wavelength is shifted. Namely, the lasing wavelength will not make a relative movement in relation to the stop band. In this case, as shown in FIG. 4, a (mode-hop free) continuous wavelength shift can be provided, in which no mode-hopping occurs at all.

Therefore, as compared with a conventional laser enlarged in continuous wavelength tuning width (wavelength tunable distributed Bragg reflector (DBR) laser with short active region), the DBR laser of the present invention is free of mode-hopping when the active region optical waveguide 22 is made longer, and provided with an equal or better continuous wavelength shift width. Further, a decrease in length of the anterior DBR region 24 will result in improvement in transmittance to provide a high output power.

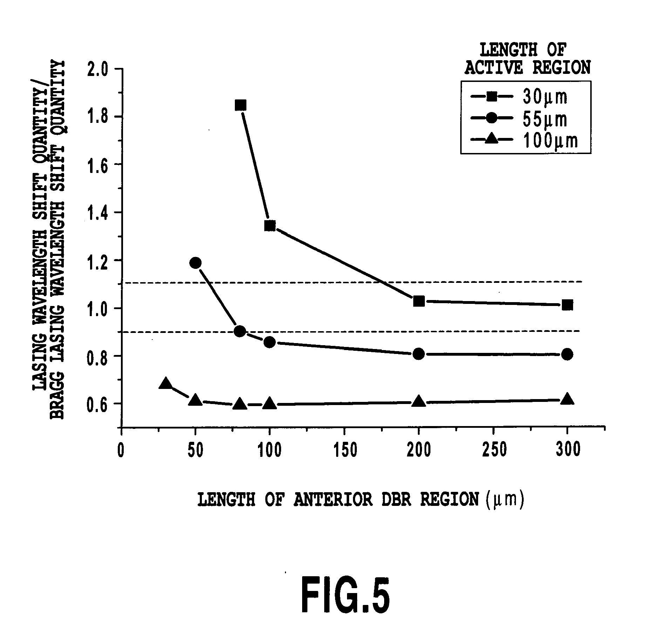

FIG. 5 is a characteristics curve showing relationship a ratio of the lasing wavelength shift quantity to the Bragg wavelength shift quantity and the length of the anterior DBR region. The length of the active region optical waveguide 22 is used as a parameter to allow the length to change to 30μm, 54.5μm and 100μm. Electrical isolating regions 25a and 25b which are in contact with both ends of the active region optical waveguide 22 are, respectively, given 10μm, the length of the posterior DBR region 29 is given 400μm and the coupling coefficient of the corrugation κ is given 100cm$^{-1}$. The length of the anterior DBR region 24 shown in the horizontal axis of FIG. 5 is allowed to change from 30, 50, 80, 100μm, to 400μm. Further, the DBR region of the wavelength tunable distributed Bragg reflector (DBR) laser used in the experiment is that whose waveguide loss is expressed by the following formula (4).

**[Formula 4]**

$$\Gamma \Delta \alpha = 5.27 \, \Delta \lambda_{Bragg} + 5.54 \quad (cm^{-1}) \quad (4)$$

In the formula (4), the left side denotes the waveguide loss in relation to propagating light, with consideration given to light confinement factor of the waveguide, whereas the right side $\Delta \lambda_{Bragg}$ denotes the Bragg wavelength shift quantity.

It is apparent from FIG. 5 that a decrease in length of the anterior DBR region 24 will approximate the requirements of the formula (3), thereby providing the continuous wavelength shift width in a wider band. Namely, where the length of the active region optical waveguide 22 is given 30μm, an ideal wavelength tuning characteristic which can satisfy the requirements of formula (3) is obtained in a range where the anterior DBR region 24 is 200μm or longer in length. However, an excessively short length of the active region optical waveguide 22 will result in shortage of the gain, and a 4nm shift of the lasing wavelength will result in a halt of the laser emission. When the length of the active region optical waveguide 22 is given 100μm, a halt of lasing will not occur, but a ratio of the lasing wavelength shift quantity to the Bragg wavelength shift quantity is in a range from 0.6 to 0.7, thus, making it impossible to provide an ideal requirement (ratio is 1). Further, a 3nm shift of the wavelength will cause mode-hopping.

In contrast, where the length of the active region optical waveguide 22 is given as 54.5μm, it is possible to provide a continuous wavelength shift in a wide band. Thus, where the length of the active region optical waveguide 22 is given as 54.5μm, a more detailed explanation will be made for the characteristic of a device having a wider band of the continuous wavelength shift and a relatively high output power (a case where the length of the anterior DBR region 24 is 80μm) by referring to the following embodiments. In this case, a ratio of the lasing wavelength shift quantity to the Bragg wavelength shift quantity is 0.9.

Embodiment 1

FIG. 1 is drawing showing a constitution of the wavelength tunable distributed Bragg reflector (DBR) laser according to Embodiment 1 of the present invention. In Embodiment 1 of the present invention, an explanation will be made for a case where InP is used as a substrate 21 to fabricate a light source having the lasing wavelength of 1.55μm. FIG. 1A is a cross sectional view showing a face vertical to the substrate 21 including optical waveguides. Further, FIG. 1B is a cross sectional view (top view) showing a face parallel to the substrate 21 including the cross section view taken along line IB-IB in FIG. 1A.

InGaAsP passive region optical waveguides, 23a and 23b, having the band gap wavelength of 1.3μm are provided on both ends (front and rear) of the InGaAsP active region opt ical waveguide 22 having the band gap wavelength of 1.57μm. The active region optical waveguide 22 is given as 54.5μm in length, electrical isolating regions 25a and 25b which are in contact with the both ends are given 10μm, the anterior DBR region 24 and the posterior DBR region 29 are, respectively, given as 80μm and 400μm, and the coupling coefficient of the corrugation κ is given 100cm$^{-1}$. FIG. 15 shows that a saturated effective length value obtained is 49.9μm when the coupling coefficient of the corrugation κ is 100cm$^{-1}$. The DBR effective length obtained is 37μm from the relationship of FIG. 14 when the anterior DBR region 24 is 80μm in length. Thus, in this case, the effective length of the anterior DBR region 24 corresponds to approximately 75% of a saturated effective length value. Although not illustrated in FIG. 1, electrical isolating regions, 25a and 25b, are a region provided by partially removing an InGaAsP layer formed on an upper clad layer for giving ohmic contact to electrodes 28a, 28b and 28C. Electrical isolating regions which separate the DBR control current 27 from the active region current 26 are formed as 25a and 25b by removing a part of the InGaAsP layer in which the electrodes 28a, 28b and 28c are not formed.

The anterior DBR region 24 was given as 80μm in length and fabricated so as to induce an appropriate change in threshold current at the time of controlling the lasing wavelength shift, thereby making measurement. In this experiment, used was a wavelength tunable distributed Bragg reflector (DBR) laser which was operated by a single mode and in which waveguide widths were all 1.5μm. The active region optical waveguide 22 may be made wider in waveguide width than the passive region optical waveguides 23a and 23b and constituted by an artificial single mode waveguide, etc., to which self-imaging effects are given.

The active region optical waveguide 22 and passive region optical waveguides 23a and 23b are optically spliced by butt joint, and a device is given a burying structure as with an ordinary wavelength tunable distributed Bragg reflector (DBR) laser. The device given a ridge structure also provides similar effects as with that given a burying structure. Further, anti-reflection films 20a and 20b are provided, respectively, on end faces of both the DBR regions.

The active region optical waveguide 22 and the passive region optical waveguides 23a and 23b are constituted by semiconductor crystals different in band gap wavelength. The active region optical waveguide 22 is provided with light-emitting functions such as electric current injection and optical excitation. The anterior DBR region 24 and the posterior DBR region 29 are provided with a wavelength tuning function in association with a change in refractive index due to the injection of the DBR control current 27.

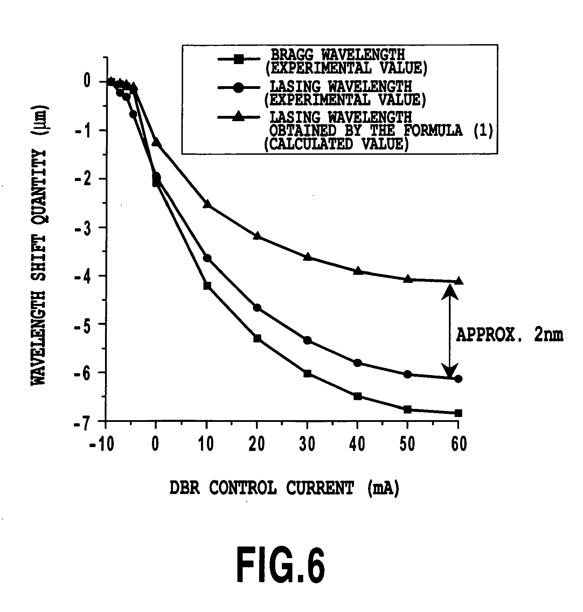

FIG. 6 is a characteristics curve showing the wavelength tuning characteristics of the wavelength tunable distributed Bragg reflector (DBR) laser according to Embodiment 1 of the present invention. The figure shows experimental values of the lasing wavelength shift quantity and those of the Bragg wavelength shift quantity. It also shows calculated values of the lasing wavelength shift quantity obtained by substituting experimental values of the above Bragg wavelength shift quantity in the formula (1). In this case, a ratio of the lasing wavelength shift quantity to the Bragg wavelength shift quantity is 0.9, in which continuous wavelength shift substantially free of mode-hopping (mode-hop free) is available. Injection of the DBR control current 27 up to 60mA makes it possible to provide a 6nm-continuous wavelength shift width. In FIG. 6, the DBR control current 27 shown in the horizontal axis starts from - 9mA because of leakage current from the active region optical waveguide 22. The DBR control current 27 in a state of -9mA corresponds to a zero bias (grounded state) of the DBR region. It is apparent from FIG. 6 that the experimental values exhibit a continuous wavelength shift which is larger than a continuous wavelength shift (calculated value) estimated from the formula (1).

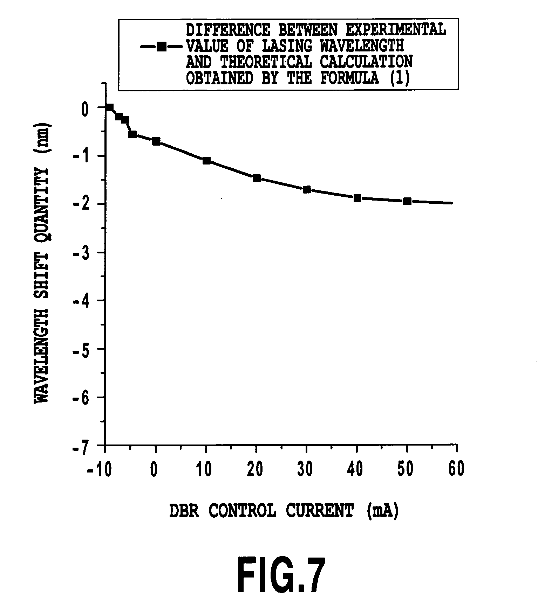

FIG. 7 is a characteristics curve explaining a difference between experimental values of the lasing wavelength and theoretical values obtained according to the formula (1) in the wavelength tunable distributed Bragg reflector (DBR) laser according to Embodiment 1 of the present invention. The vertical axis shows a difference between experimental values of the continuous wavelength shift quantity of the lasing wavelength and theoretical values of continuous wavelength shift quantity of the lasing wavelength obtained according to the formula (1). The horizontal axis shows the DBR control current. It is apparent from FIG. 7 that an increased DBR control current 27 results in the continuous wavelength shift quantity which is about 2mm larger than calculated values of the continuous wavelength shift quantity estimated by the conventional formula (1).

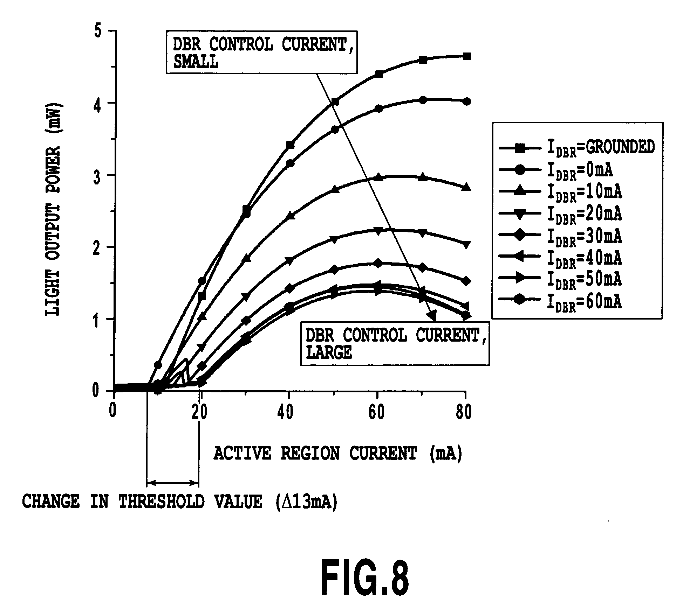

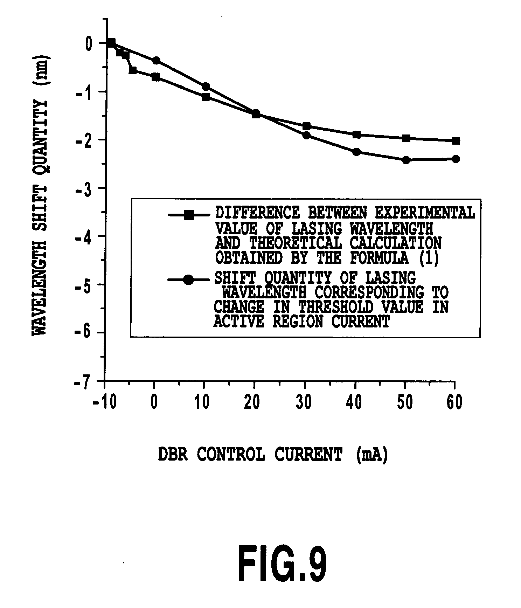

FIG. 8 is a characteristics curve showing the I-L characteristic of the wavelength tunable distributed Bragg reflector (DBR) laser according to Embodiment 1 of the present invention. In order to demonstrate the effect of the present embodiment 1 in detail, a dependency of light output power (I-L characteristics) on the active region current 26 is allowed to change from a grounded state of the DBR control current 27 to 60mA to make measurement. When the active region current 26 reaches a threshold current, the present wavelength tunable distributed Bragg reflector (DBR) laser starts to emit. It is confirmed from FIG. 8 that an increase in DBR control current 27 will result in a gradual increase in threshold current from 7mA to 20mA to induce a change in threshold current of 13mA. Further, a high light output power from 1mW up to 4. 7mW is obtained even at the time of controlling the lasing wavelength shift. FIG. 9 is a characteristics curve showing a comparison of the lasing wavelength shift quantity given in FIG. 7 with the lasing wavelength shift quantity caused by a change in threshold current in the wavelength tunable distributed Bragg reflector (DBR) laser according to Embodiment 1 of the present invention. Plots of the above-described lasing wavelength shift quantity due to a change in threshold current (threshold current values obtained when the DBR control current 27 is grounded are calculated, with leakage current to the DBR region 27 taken into account) and plots given in FIG. 7 are shown on the same graph. These plots are in satisfactory agreement.

As explained so far in detail, it is apparent that the wavelength tunable distributed Bragg reflector (DBR) laser of the present embodiment 1 is able to provide a continuous wavelength shift in a wider band than a conventional wavelength tunable distributed Bragg reflector (DBR) laser. A conventional theoretical value of the mode-hop free continuous wavelength shift quantity (range) is calculated according to the formula (2) to give 4nm (lasing wavelength tuning range derived from a change in refractive index of the DBR region). As compared with this theoretical value, an experimental value of the continuous wavelength shift quantity in the wavelength tunable distributed Bragg reflector (DBR) laser according to Embodiment 1 is larger by approximately 2nm and provided with a wider continuous wavelength shift range. Further, a sufficiently high light output power is also obtained.


Embodiment 2


In Embodiment 2, a wavelength tunable distributed Bragg reflector (DBR) laser was fabricated by coating the facet with a high-reflection film but removing the posterior passive region optical waveguide 23b provided in the wavelength tunable distributed Bragg reflector (DBR) laser according to Embodiment 1.

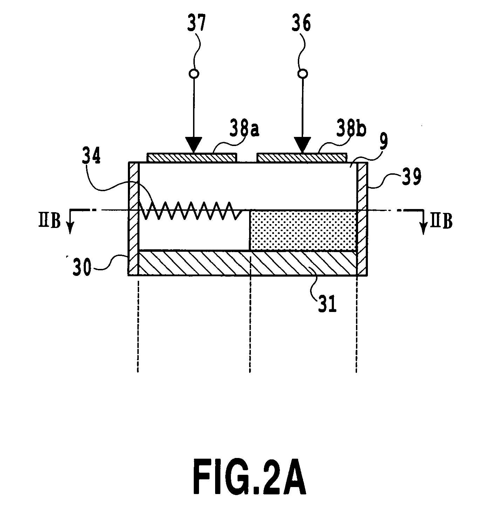

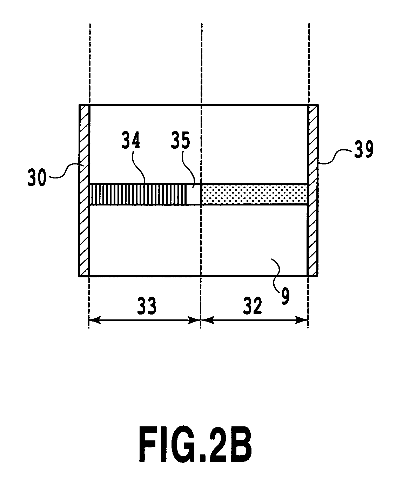

FIG . 2 is a view showing a structure of the wavelength tunable distributed Bragg reflector (DBR) laser according to Embodiment 2. FIG. 2A is a cross sectional view showing a face vertical to the substrate 31 including optical waveguides. FIG. 2B is a cross sectional view (top view) showing a face parallel to the substrate 31 including the cross section taken line IIB-IIB in FIG. 2A. As shown in FIG. 2A, Embodiment 2 is the same as Embodiment 1 in structure in that the active region optical waveguide 32 and the passive region optical waveguide 33 are provided and the DBR region 34 is formed in the passive region optical waveguide 33. Embodiment 2 of the present invention is not provided with the posterior passive region optical waveguide having a long DBR region as provided in Embodiment 1 but alternatively provided with the high-reflection film 39 with the reflectivity of 90%. An end face of the passive region optical waveguide 33 is coated with an anti-reflection film 30. An upper clad layer 9 is formed above and on the side of the active region optical waveguide 32 and the passive region optical waveguide 33. Electrodes 38a and 38b are also formed on the clad layer 9, and the DBR control current 37 and the active region current 36 are injected from the respective electrodes.
The length of the active region optical waveguide 32 was given 40$\mu$m and other structures and device parameters were the same as those in Embodiment 1.

The wavelength tunable distributed Bragg reflector (DBR) laser according to Embodiment 2 was used to obtain a 6nm-continuous wavelength shift range and 1mW or more output power, as obtained in Embodiment 1.


Embodiment 3


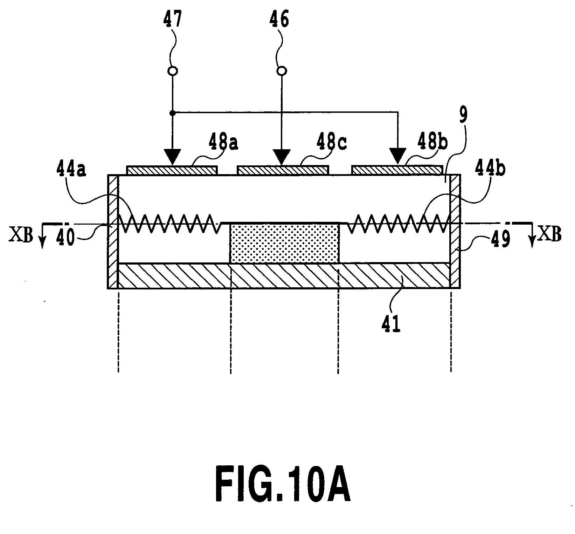

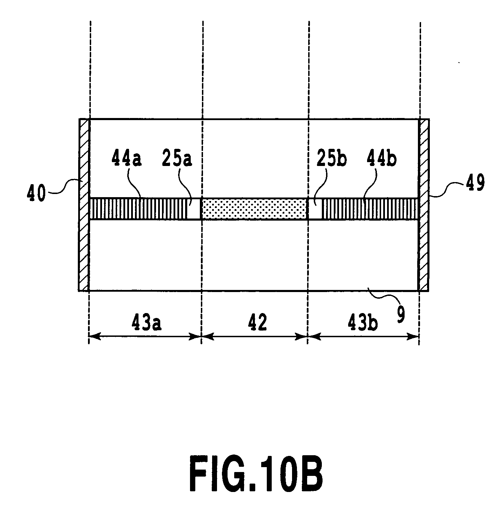

FIG. 10 is a view showing a structure of the wavelength tunable distributed Bragg reflector (DBR) laser according to Embodiment 3 of the present invention. FIG. 10A is a cross sectional view showing a face vertical to the substrate 41 including optical waveguides. FIG. 10B is a cross sectional view (top view) showing a face parallel to the substrate 41 including the cross section taken along XB-XB of FIG. 10A.
The wavelength tunable distributed Bragg reflector (DBR) laser of the present embodiment 3 is provided on a substrate 41 with an active region optical waveguide 42 and passive region optical waveguides 43a and 43b at both ends of the active region optical waveguide 42, as similar to Embodiment 1. The passive region optical waveguides 43a and 43b are provided, respectively, with DBR regions 44a and 44b. An upper clad layer 9 is formed above and on the side of the active region optical waveguide 42 and passive region optical waveguides 43a and 43b. Further, electrodes 48a and 48b for injecting the DBR control current 47 and an electrode 48c for injecting the active region current 46 are formed above the upper clad layer 9. The electrode 48a and 48b and the electrode 48c are electrically isolated by electrical isolating regions 25a and 25b which are a high-resistant region. An end face of the passive region optical wavelength 43a is coated with an anti-reflection film 40, and another end face of the passive region optical waveguide 43b is coated with a high-reflection film 49. Embodiment 3 is provided with the passive region optical waveguides 43a and 43b in which the respective DBR regions are given a length corresponding to an effective length shorter than a saturated effective length value. To be specific, in Embodiment 1, the DBR region of one passive region optical waveguide is given a length corresponding to effective length which is 95% or more in a saturated effective length value, and that of the other passive region optical waveguide is shorter than the length. In contrast, Embodiment 3 of the present invention is provided with passive region optical waveguides 43a and 43b in which both of the DBR regions are given a length corresponding to effective length shorter than a saturated effective length value. It is constituted in such a way that an end face of one passive region optical waveguide 43 is coated with a high-reflection film 49 and another end face of the other passive region optical waveguide 43a is coated with an anti-reflection film 40. Emitting light is outputted from an end face having the anti-reflection film 40. Since the DBR effective length is shorter than a saturated effective length value in the passive region optical waveguide 43b on the side having the high-reflection film 49, the reflectivity is not sufficient. However, a sufficient reflectivity can be provided by coating the facet with the high-reflection film 49.

The wavelength tunable distributed Bragg reflector (DBR) laser according to Embodiment 3 of the present invention is constituted in such a way that the DBR region on a high reflection side is given as 80μm in length, and both the DBR regions, namely, both the passive region optical waveguides 43a and 43b are given the same length. As a matter of course, the present invention is not limited to a case where both of the passive region optical waveguides are given the same length (in Embodiment 3 of the present invention, both of the DBR regions happen to be the same in length). Other device parameters are the same as those in Embodiment 1.

According to the structure of Embodiment 3, it is possible to downsize an entire device of the wavelength tunable distributed Bragg reflector (DBR) laser. The wavelength tunable distributed Bragg reflector (DBR) laser according to Embodiment 3 has provided a continuous wavelength shift range of 6mm and a high light output power of 1mW or more, as similar to Embodiment 1.

Embodiment 4

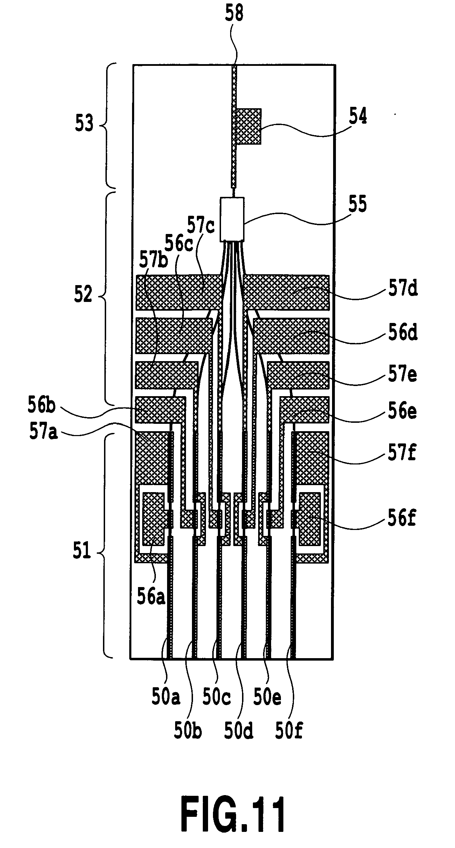

FIG. 11 is a top view showing a structure of the integrated wavelength tunable distributed Bragg reflector (DBR) laser array according to Embodiment 4 of the present invention. The wavelength tunable distributed Bragg reflector (DBR) laser array is provided on a single substrate with a plurality of wavelength tunable distributed Bragg reflector (DBR) lasers 50a, 50b, 50C, 50d, 50e and 50f according to the above-described present invention. A plurality of wavelength tunable distributed Bragg reflector (DBR) lasers constitute a DBR-LD array section 51. The respective outputs of the wavelength tunable distributed Bragg reflector (DBR) lasers 50a, 50b, 50c, 50d, 50e and 50f, are coupled by an optical coupler 55, constituting an optical coupler section 52 which is converted to one port. Further, the output from the optical coupler section 52 is connected to alight amplifying section 53 which adjusts the level of coupled power. Electrodes 57a, 57b, 57c, 57d, 57e and 57f for injecting a DBR control current are arrayed on DBR regions of the respective wavelength tunable distributed Bragg reflector (DBR) lasers 50a, 50b, 50c, 50d, 50e and 50f. The electrodes 56a, 56b, 56c, 56d, 56e and 56f for injecting an active region current are arrayed on an active region. The present wavelength tunable distributed Bragg reflector (DBR) laser array is constituted to be symmetrical, to which the present invention is not limited.

The respective wavelength tunable distributed Bragg reflector (DBR) lasers 50a, 50b, 50c, 50d, 50e and 50f are different in pitch of the respective diffraction gratings and also different in continuous wavelength tuning range in which the wavelength is tunable. To be specific, the 6 outputs from optical sources in which DBR regions are different in pitch of the diffraction grating are coupled by means of the optical coupler 55 into one port, by which a wider-band wavelength tuning DBR-LD array capable of attaining a wavelength tuning is fabricated. In Embodiment 4 of the present invention, the photo coupler section 52 is constituted by S-shape curved optical waveguides and MMI couplers (multi-mode interference coupler). The coupler section is not limited to a MMI coupler, as long as light can be concentrated on one port.

An output end 58 is provided with the light amplifying section 53 for adjusting a light output power. An anti-reflection film is given to an end face of the output end 58 of the light amplifier and end face of the DBR-LD array 51.

Respective integrated lasers were able to attain a 6nm-continuous wavelength tuning, and a total of 36nm (6 × 6nm = 36nm : 1530-1566nm) continuous wavelength tuning width is provided. At the same time, light output power of 10mW or more is provided. The respective wavelength tunable distributed Bragg reflector (DBR) lasers 50a, 50b, 50c, 50d, 50e and 50f in Embodiment 4 of the present invention is not limited to the wavelength tunable distributed Bragg reflector (DBR) laser according to Embodiment 1, but that according to Embodiment 2 or Embodiment 3 may be used.

**Claims**

1. A wavelength tunable distributed Bragg reflector (DBR) laser having optical waveguides surrounded by a clad layer on a substrate, comprising;

   a first passive region optical waveguide including a first DBR region having a diffraction grating in a section whose length corresponds to effective length of 95% or more in a saturated effective length value, wherein the lasing wavelength is controlled by a DBR control current,
   a second passive region optical waveguide including a second DBR region having a diffraction grating in a section whose length is shorter than the first DBR region, wherein the lasing wavelength is controlled by the DBR control current, and
   an active region optical waveguide in which the first passive region optical waveguide and the second passive region optical waveguide are optically connected at both ends, wherein emission state is controlled by the active region current, irrespective of the DBR control current.

2. A wavelength tunable distributed Bragg reflector (DBR) laser according to Claim 1, wherein the first passive region optical waveguide includes a first electrical isolating region between the first DBR region and the active region optical waveguide, and the second passive region optical waveguide contains a second electrical isolating region between the second DBR region and the active region optical waveguide.

3. A wavelength tunable distributed Bragg reflector (DBR) laser according to Claim 1 and Claim 2, wherein an effective length of the second DBR region is 75% or less in the saturated effective length value.

4. A wavelength tunable distributed Bragg reflector (DBR) laser according to any one of Claim 1 through Claim 3, further comprising an anti-reflection film provided on an end face of the first passive region optical waveguide opposite the active region optical waveguide and an end face of the second passive region optical waveguide opposite the active region optical waveguide.

5. A wavelength tunable distributed Bragg reflector (DBR) laser having optical waveguides surrounded by a clad layer on a substrate, comprising;

   a first passive region optical waveguide including a first DBR region having a diffraction grating in a section whose length corresponds to effective length of 75% or less in a saturated effective length value, wherein the lasing wavelength is controlled by a DBR control current,
   a second passive region optical waveguide including a second DBR region having the diffraction grating in a section whose length corresponds to effective length of 75% or less in a saturated effective length value, wherein the lasing wavelength is controlled by the DBR control current,
   an active region optical waveguide in which the first passive region optical waveguide and the second passive region optical waveguide are optically connected at both ends, wherein emission state is controlled by the active region current, irrespective of the DBR control current,
   a high-reflection film coating an end face of the first passive region optical waveguide opposite the active region optical waveguide, and
   an anti-reflection film coating an end face of the second passive region optical waveguide opposite the active region optical waveguide.

6. A wavelength tunable distributed Bragg reflector (DBR) laser according to Claim 5, wherein the first passive region optical waveguide includes a first electrical isolating region between the first DBR region and the active region optical waveguide, and the second passive region optical waveguide includes a second electrical isolating region between the second DBR region and the active region optical waveguide.

7. A wavelength tunable distributed Bragg reflector (DBR) laser having optical waveguides surrounded by a clad layer on a substrate, comprising;

   a passive region optical waveguide including a DBR region having a diffraction grating in a section whose length corresponds to effective length of 75% or less in a saturated effective length value, wherein the lasing wavelength is controlled by a DBR control current,
   an active region optical waveguide which is optically connected to the passive region optical waveguide, wherein emission state is controlled by the active region current irrespective of the DBR control current,

an anti-reflection film coating an end face of the passive region optical waveguide opposite the active region optical waveguide, and
a high-reflection film coating an end face of the active region optical waveguide opposite the passive region optical waveguide.

8.  A wavelength tunable distributed Bragg reflector (DBR) laser according to Claim 7, wherein the passive region optical waveguide includes an electrical isolating region between the DBR region and the active region optical waveguide.

9.  A wavelength tunable distributed Bragg reflector (DBR) laser according to any one of Claim 1 through Claim 8, wherein the length of the active region optical waveguide is in a range from 30μm to 100μm.

10. An integrated wavelength tunable distributed Bragg reflector (DBR) laser, comprising;

a plurality of wavelength tunable distributed Bragg ref lector (DBR) lasers according to any one of Claim 1 through Claim 9, in which the plurality of wavelength tunable distributed Bragg reflector (DBR) lasers respectively have different pitches of the diffraction grating,
an optical coupler for coupling output lights from each of the plurality of wavelength tunable distributed Bragg reflector (DBR) lasers to one port to output a coupled light, and
an optical semiconductor amplifier for adjusting the output level of the coupled light.

11. A wavelength tunable distributed Bragg reflector (DBR) laser according to any one of Claim 1 through Claim 10, wherein a ratio of the lasing wavelength shift quantity to the Bragg wavelength shift quantity is in a range from 0.9 to 1.1.

FIG.1A

FIG.1B

## FIG.2A

**FIG.2B**

# FIG.3A

**FIG.3B**

FIG.3C

DBR CONTROL CURRENT

FIG.4

FIG.5

FIG.6

FIG.7

FIG.8

FIG.9

**FIG.10A**

# FIG.10B

FIG.11

**FIG.12A**

EP 1 729 381 A1

EP 1 729 381 A1

14a    15a        15b    14b

13a              12              13b

9

**FIG.12B**

# FIG.13

FIG.14

| COUPLING COEFFICIENT $\kappa$ (cm$^{-1}$) | SATURATION VALUE OF THE EFFECTIVE LENGTH (cm$^{-1}$) |
|---|---|
| 40 | 123.9 |
| 50 | 99.5 |
| 60 | 83.0 |
| 70 | 71.2 |
| 80 | 62.4 |
| 90 | 55.5 |
| 100 | 49.9 |
| 110 | 45.4 |
| 120 | 41.6 |
| 130 | 38.4 |
| 140 | 35.7 |
| 150 | 33.3 |

# FIG.15

FIG.16

FIG.17A

**FIG.17B**

FIG.17C

FIG.18

FIG.19

## INTERNATIONAL SEARCH REPORT

| International application No. |
| --- |
| PCT/JP2005/005246 |

**A. CLASSIFICATION OF SUBJECT MATTER**
Int.Cl⁷ H01S5/125

According to International Patent Classification (IPC) or to both national classification and IPC

**B. FIELDS SEARCHED**

Minimum documentation searched (classification system followed by classification symbols)
Int.Cl⁷ H01S5/125

Documentation searched other than minimum documentation to the extent that such documents are included in the fields searched

| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
JICST FILE(JOIS)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | Naoki FUJIWARA et al., "Hacho Sentakugata Mode-hop-free DBR Laser Array", The Institute of Electronics, Information and Communication Engineers Gijutsu Kenkyu Hokoku, OPE2003-22 to 33, 2003, pages 47 to 50 | 1-2,4,9-10<br>11<br>3,5-8 |
| X<br>Y<br>A | N. FUJIWARA et al., Mode-hop-free wavelength-tunable distributed Bragg reflector laser, ELECTRONICS LETTERS, Vol.39, No.7, 2003, pages 614 to 615 | 1-2,4,9<br>10-11<br>3,5-8 |
| A | JP 3-44084 A (Nippon Telegraph And Telephone Corp.),<br>25 February, 1991 (25.02.91),<br>Fig. 1<br>(Family: none) | 7-8 |

☒ Further documents are listed in the continuation of Box C.   ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>06 April, 2005 (06.04.05) | Date of mailing of the international search report<br>26 April, 2005 (26.04.05) |
| --- | --- |
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

| International application No. |
|---|
| PCT/JP2005/005246 |

C (Continuation).    DOCUMENTS CONSIDERED TO BE RELEVANT

| Category* | Citation of document, with indication, where appropriate, of the relevant passages | Relevant to claim No. |
|---|---|---|
| A | US 6638773 B1  (Applied Optoelectronics, Inc.),<br>28 October, 2003 (28.10.03),<br>Column 11, lines 7 to 15, 52 to 56; Fig. 1<br>& WO 03-103107 A1 | 1-4 |

Form PCT/ISA/210 (continuation of second sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Semiconductor Photonics Engineering. Tatsuhiko Ikegami by Corona Corporation, 10 January 1995, 306-311
- **KENICHI IGA.** Semiconductor Laser. Ohmsha, 25 October 1994, 283-288

- *Research on high performance process of wavelength tuning semiconductor laser,* 39-4354-5965-68